# EUROPEAN PATENT APPLICATION

(11) **EP 2 400 248 A1**
(43) Date of publication of application: **28.12.2011**
(21) Application number: 10743505.9
(22) Date of filing: 01.02.2010
(51) Int. Cl.: F28D 15/02, H01L 23/427

(54) **EBULLIENT COOLING APPARATUS**

(30) Priority: 23.02.2009 JP 2009039249
(71) Applicant: Kabushiki Kaisha Toyota Jidoshokki, Kariya-shi, Aichi 448-8671 (JP)
(72) Inventor: YOSHIHARA, Koji, Kariya-shi Aichi 448-8671 (JP); HARIU, Satoshi, Kariya-shi Aichi 448-8671 (JP)
(74) Representative: TBK
(86) International application number: PCT/JP2010/000582
(87) International publication number: WO 2010/095373

(57) **Abstract**

To provide an ebullient cooling device that can prevent the freezing of liquid cooling medium, and which can inhibit the occurrence of burnout.

An ebullient cooling device according to the present invention is **characterized in that**: it comprises an accommodating unit in which a liquid cooling medium is accommodated, the liquid cooling medium receiving heat that results from a heating element; the liquid cooling medium is a mixed liquid comprising at least two types of liquids whose boiling points differ; the accommodating unit has: a heat-transferring wall portion that conveys the heat of the heating element to the liquid cooling medium; and a facing wall portion that faces the heat-transferring wall portion by way of the liquid cooling medium; and a separation distance between the heat-transferring wall portion and the facing wall portion is 3 mm or less.

## Description

### TECHNICAL FIELD

The present invention is one which relates to an ebullient cooling device that uses a cooling medium.

### BACKGROUND ART

An ebullient cooling device is a device for cooling a heating element utilizing the phase change of a cooling medium from liquid to gas. Here, in sealed-system ebullient cooling devices, it is often the case that the liquid cooling media, which receive heat from the heating elements, are alcohols. For example, in Japanese Unexamined Patent Publication (KOKAI) Gazette No. 4-257,693 (or Patent Literature No. 1), there is set forth a mixed liquid of water (100) and a lower alcohol (from 5 to 12). The cooling medium herein is intended for heat pipe that is used to cool indoor instruments mainly, and is made so as not to be freezable at -10°C approximately, and to be nonflammable.

Moreover, in Japanese Unexamined Utility Model Publication (KOKAI) Gazette No. 62-8,571 (or Patent Literature No. 2), there is set forth a mixed liquid of water and an alcohol. The freezing of the cooling medium is prevented herein by changing the blending ratio of the water with the alcohol.

Meanwhile, the following studies have also been carried out in ebullient cooling devices: what the heat-transfer characteristics, and the like, have become of depending on the spatial constructions between the parts for accommodating the liquid cooling media like those mentioned above and the parts for conveying the heating elements' heat to the liquid cooling media. For example, in "Nucleate-boiling Heat Transfer at Narrow Gap" (or Non-patent Literature No. 1) according to A112 in the collection of lecture papers in the Twenty-second Japan Heat-transfer Symposium (May, 1985), there are set forth relationships between heat-transfer characteristics and separation distances between the heat-transferring faces and the other faces facing thereto.
Patent Literature No. 1: Japanese Unexamined Patent Publication (KOKAI) Gazette No. 4-257,693;
Patent Literature No. 2: Japanese Unexamined Utility Model Publication (KOKAI) Gazette No. 62-8,571; and
Non-patent Literature No. 1: "Nucleate-boiling Heat Transfer at Narrow Gap" according to A112 in the collection of lecture papers in the Twenty-second Japan Heat-transfer Symposium (May, 1985)

### DISCLOSURE OF THE INVENTION

### Assignment to be Solved by the Invention

In ebullient cooling devices, there is such a possibility that burnout (or film boiling) might occur with respect to heating elements that give rise to high heat fluxes. In a region where burnout has occurred, the cooling performance has declined because no heat transfer is carried out. Hence, it has been heretofore required conventionally to inhibit the occurrence of burnout. Recently, however, the more electronic instruments, and the like, are downsized, or the more they are highly integrated, the higher the resultant heat fluxes (or heat-generation densities) become (1 MW/m² approximately, for instance), and hence burnout becomes likely to occur.

Moreover, in a case where water is used as a cooling medium, burnout becomes less likely to occur because a limit heat flux that the resultant cooling medium possesses becomes greater. However, water has become inadequate for the installation onto vehicle, because it has such a high melting point that it has frozen readily. Meanwhile, in a case where an alcohol is used as a cooling medium, it becomes less likely to freeze because it has a low melting point. However, alcohol has aproblemwith the prospect of inhibitingburnout, because it has a smaller limit heat flux compared with that of water.

The present invention is one which has been done in view of such circumstances, and it is an object to provide an ebullient cooling device that can inhibit the freezing of liquid coolingmedium, and which can inhibit the occurrence of burnout.

### Means for Solving the Assignment

An ebullient cooling device according to the present invention is **characterized in that**:
it comprises
   an accommodating unit in which a liquid cooling medium is accommodated, the liquidcoolingmediumreceivingheat that results from a heating element;
the liquid cooling medium is a mixed liquid comprising at least two types of liquids whose boiling points differ;
the accommodating unit has:
   a heat-transferring wall portion that conveys the heat of the heating element to the liquid cooling medium; and
   a facing wall portion that faces the heat-transferring wall portion by way of the liquid cooling medium; and
a separation distance between the heat-transferring wall portion and the facing wall portion is 3 mm or less.

By means of using the mixed liquid as a liquid cooling medium, it is possible to adjust the melting point so as to conform to required specifications, and it becomes feasible to prevent the liquid cooling medium from freezing. And, by setting the separation distance between the heat-trans ferringwall portion and the facingwall portion to 3 mm or less, heat transfer becomes favorable, and thereby the occurrence of burnout can be inhibited.

Here, it is preferable that the separation distance between the heat-transferring wall portion and the facing wall portion can be 2 mm or less. In accordance with this setting, heat transfer becomes favorable furthermore, and thereby the occurrence of burnout can be inhibited. In addition, it is preferable that the separation distance between the heat-transferring wall portion and the facing wall portion canbe from 0.5 mm or more to 1.5 mm or less. In accordance with this setting, heat transfer becomes more favorable, and thereby the occurrence of burnout can be inhibited.

Here, it is preferable that the liquid cooling medium can be a mixed liquid of water and ethanol. Since ethanol has a lower melting point compared with those of the other alcohols, it is likely to lower the melting points in mixed liquids with water. That is, it is allowable that an amount of ethanol, which is needed for the mixed liquid in order to reach a targeted melting-point temperature, can be less than those when the other alcohols are mixed. Therefore, compared with the other alcohols, it is possible to make the proportion of water in the mixed liquid larger, and so it is possible to make the mixed liquid greater in the limit heat flux.

Moreover, ethanol has a larger heat of evaporation (or latent heat) compared with those of the other alcohols. Therefore, using ethanol makes the resulting limit heat flux much greater. In addition, ethanol is effective as a cooling medium for ebullient cooling, because it has such a low melting point relatively that makes the efficiency of thermal circulation better. Moreover, since ethanol has a boiling point that is not too low, namely, since the boiling point of ethanol is higher than a temperature (65°C, for instance) in a cooling medium (or coolant water, for instance) that has been used for condensing at condensing units in general, ethanol is more suitable for ebullient cooling. In particular, heat-transferring performance upgrades greatly by using the aforementionedmixed liquid in which bubbles rise at larger speeds in the aforesaid narrow gap. In accordance with above settings, freezing can be prevented by using a mixed liquid of water and ethanol, and the occurrence of burnout can be inhibited as well.

Furthermore, it is preferable that the aforementioned mixed liquid can have an ethanol concentration of from 45% by mass or more to 55% by mass or less. Since the resulting melting point becomes less than -30°C in accordance with this setting, it is possible to clear the specification that is generally required for the installation in vehicle (being non-freezable at -30°C, for instance) securely. Moreover, to such an extent that water is included in the mixed liquid, the liquid cooling medium becomes greater in the limit heat flux than does the alcoholic single component. In accordance with this setting, the occurrence of burnout can be inhibited.

Note herein that it is even advisable that the ebullient cooling device according to the present invention can further comprise a condensing unit that lies successively to the accommodating unit, and which condenses the liquid cooling medium that has been boiled by means of the heat of the heating element; and can be a sealed-system ebullient cooling device.

### Effect of the Invention

In accordance with the ebullient cooling device according to the present invention, the occurrence of burnout can be inhibited.

### BRIEF DESCRIPTION OF THE DRAWINGS

Fig. 1 is a schematic perspective diagram that illustrates an ebullient cooling device 1;
Fig. 2 is a cross-sectional diagram being viewed in the direction of "A"-"A" in Fig. 1;
Fig. 3 is a diagram that shows the characteristics of each of alcohols;
Fig. 4 is a diagram that shows a relationship between ethanol concentrations in ethanol-water mixed liquids and limit heat fluxes thereof;
Fig. 5 is a diagram that shows a relationship between separation distances and heat transfer coefficients;
Fig. 6 is a diagram that shows a relationship between return-separation distances and heat transfer coefficients;
Fig. 7 is a diagram that shows a relationship between ethanol concentrations in ethanol-water mixed liquids and heat transfer coefficients thereof;
Fig. 8 is a schematic diagram for explaining filmboiling;
Fig. 9 is a diagram that shows relationships between ethanol concentrations in ethanol-water mixed liquids and temperatures of elements;
Fig. 10 is a schematic diagram that illustrates a simplified makeup of an experiment;
Fig. 11 is a diagram that illustrates relationships between outputs of heating element and measured temperatures of thermocouple in the experiment; and
Fig. 12 is a diagram that illustrates an ebullient cooling device 100, and which corresponds to the "A"-"A" cross-sectional diagram.

### Explanation on Reference Numerals

1, and 100: Ebullient Cooling Devices;
2, and 20: Accommodating Units;
21: Heat-receiving Passage;
201: First Heat-receiving Passage;
202: Second Heat-receiving Passage;
22, and 203: Supplying Passages;
21a, 201a, 201b, 202a, and202b: Heat-transferring Wall Portions;
23a: Facing Wall Portion
3, and 30: Condensing Units;
31, 301, and 302: Condensing Pipes;
23, 51, and 52: Partition Plates; and
"Z," and "Z1" through "Z4": Heating Elements

### MODES FOR CARRYING OUT THE INVENTION

Next, the present invention will be explained in more detail while giving an embodiment mode.

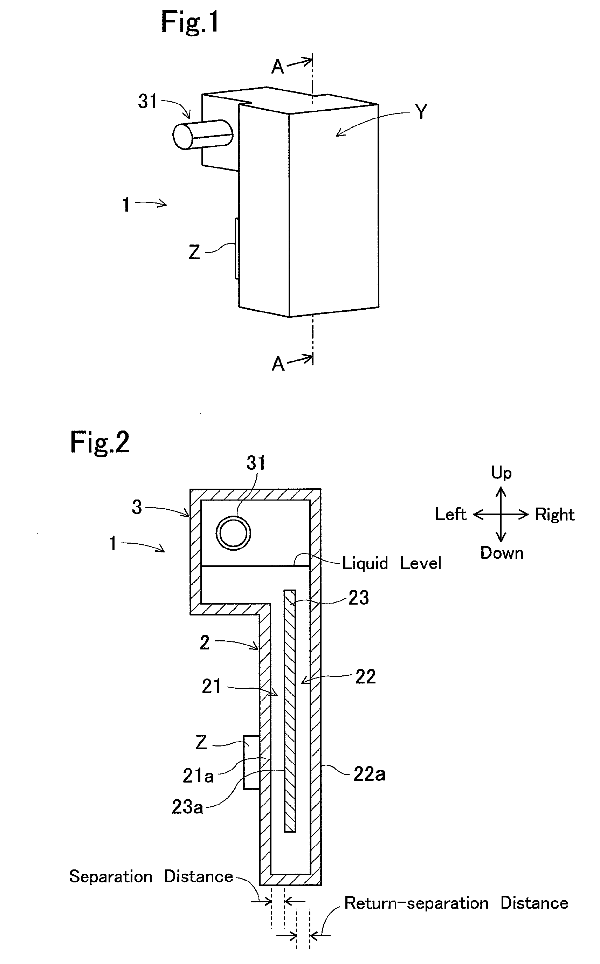

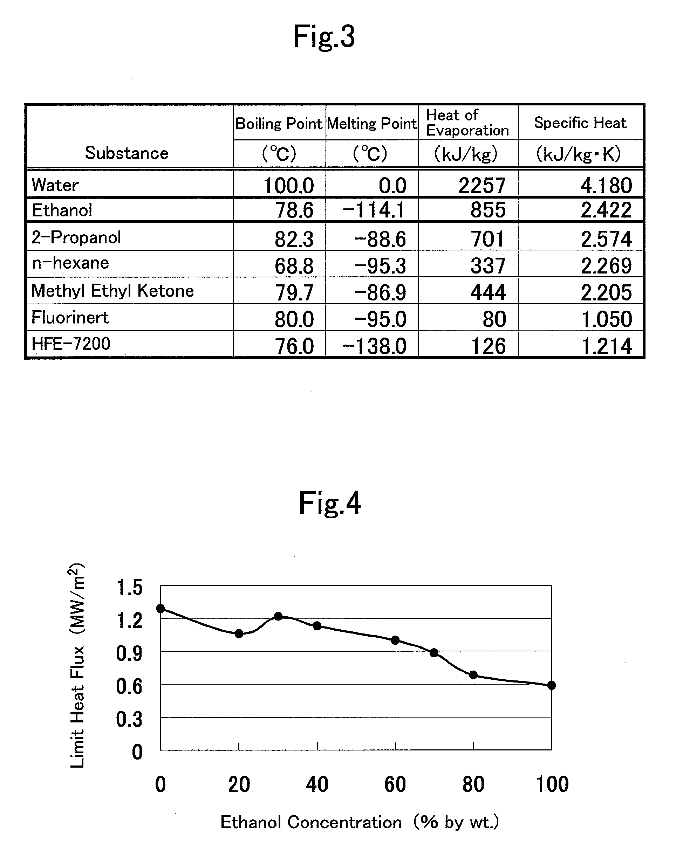

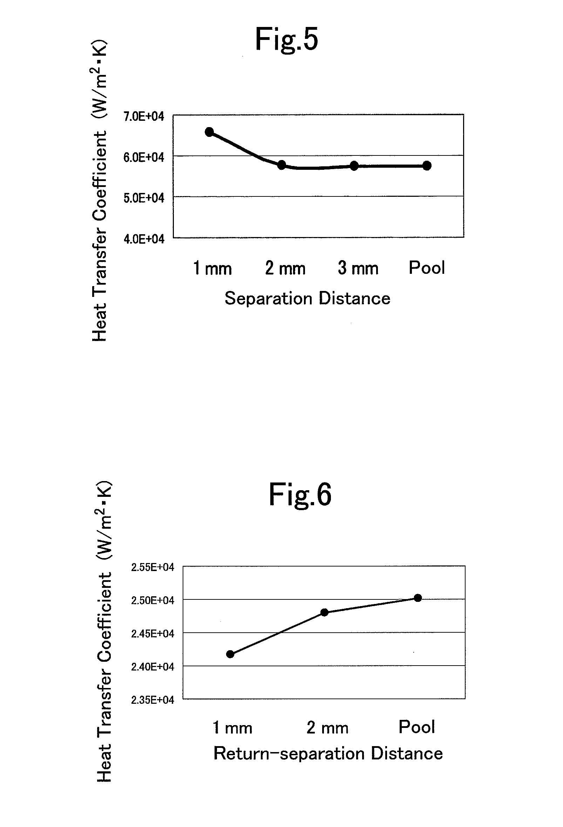

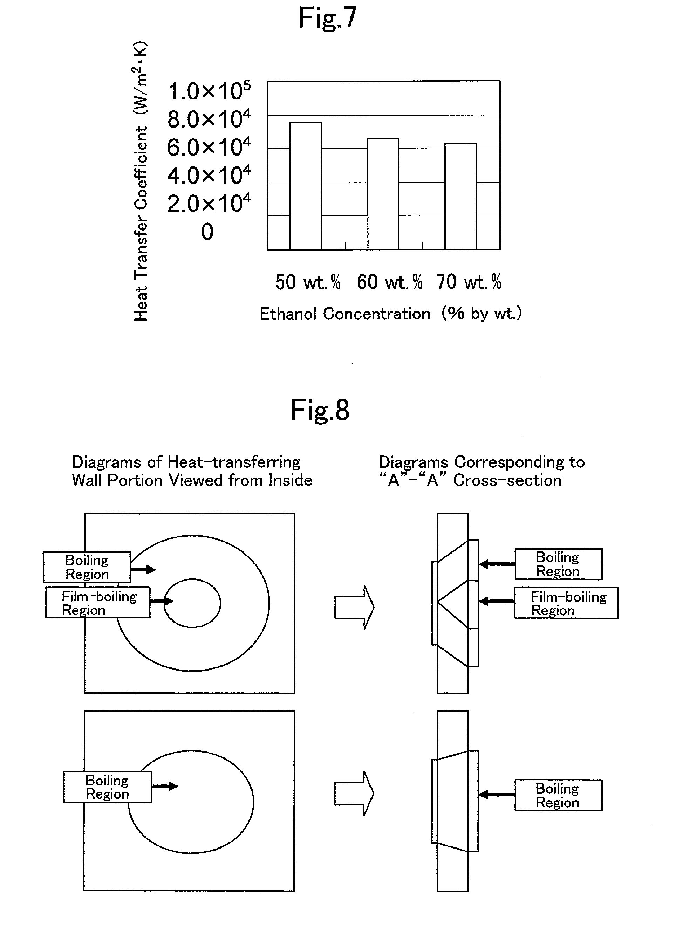

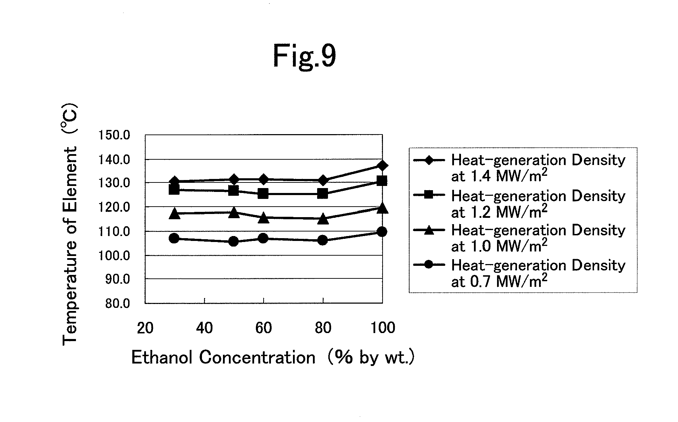

Explanations will be made on an ebullient cooling device according to the present embodiment mode with reference to Fig. 1 through Fig. 9. Fig. 1 is a schematic perspective diagram that illustrates an ebullient cooling device 1. Fig. 2 is a cross-sectional diagram being viewed in the direction of "A"-"A" in Fig. 1. Fig. 3 is a diagram that shows the characteristics of each of alcohols. Fig. 4 is a diagram that shows a relationship between ethanol concentrations in ethanol-water mixed liquids and limit heat fluxes thereof. Fig. 5 is a diagram that shows a relationship between separation distances and heat transfer coefficients. Fig. 6 is a diagram that shows a relationship between return-separation distances and heat transfer coefficients. Fig. 7 is a diagram that shows a relationship between ethanol concentrations in ethanol-water mixed liquids and heat transfer coefficients thereof. Fig. 8 is a schematic diagram for explaining film boiling. Fig. 9 is a diagram that shows relationships between ethanol concentrations in ethanol-water mixed liquids and temperatures of elements. Note that Fig. 4 is cited from "Matorir, A.S., Heat Transfer Soviet Research, 5-1 (1973), pp. 85-89."

As illustrated in Fig. 1 and Fig. 2, an ebullient cooling device 1 comprises a container "Y" whose inner space is divided by a partition plate 23, and is equipped with an accommodating unit 2, and a condensing unit 3.

The accommodating unit 2 is a metallic container having a rectangular parallelepiped configuration, and a liquid cooling medium is collected and stored in the interior. The accommodating unit 2 is equipped with a heat-receiving passage 21, a supplying passage 22, and the partition plate 23. The heat-receiving passage 21 is apart that is surrounded by four faces that include the following: a side wall face including a heat-receiving wall portion 21a onto which a heating element "Z" in the accommodating unit 2 is to be installed; the partition plate 23 that faces the aforesaid side wall face; and the side wall faces of the front side and rear side of the container "Y" (i.e., the near side and far side in Fig. 2 that are put perpendicularly to the page). The partition plate 23 forms one of the side faces of the heat-receiving passage 21, and one of the side faces of the supplying passage 22, thereby dividing the inner space of the accommodating unit 2 into the heat-receiving passage 21 and the supplying passage 22. The heating element "Z" is a semiconductor element, or the like, for instance.

The heat-receiving passage 21 is formed as a rectangular parallelepiped configuration substantially, is opened at the top to lie successively to the condensing unit 3, and is opened at the bottom to lie successively to the supplying unit 2. The heat-transferring wall portion 21a, and the partition plate 23 are parallel to each other, and a part of the partition plate 23, namely, a part thereof that faces the heat-transferring wall portion 21a, is designated a facing wall portion 23a. In the present embodiment mode, a separation distance between the heat-transferring portion 21a and the facing wall portion 23a is made to be roughly 1 mm.

The heat-receiving passage 21 is filled up by means of the liquid cooling medium. The heat-transferring wall portion 21a of the heat-receiving passage 21 is a part that conveys heat resulting from the heating element "Z" to the liquid coolingmedium. The liquid cooling medium inside the heat-receiving passage 21 receives the heat of the heating element "Z" to boil, and then turns into bubbles to rise within the liquid cooling medium. The supplying passage 22 will be described later.

The condensing unit 3 is positioned above the accommodating unit 2, and is opened at the bottom to lie successively to the heat-receiving passage 21, and to the supplying passage 22. In the condensingunit 3, a condensingpipe 31 is disposed. In the condensing pipe 31, coolant water is flowing. The condensing unit 3 cools and then condenses vapors that rise from the heat-receiving passage 21.

The supplyingpassage 22 parallels theheat-receivingpassage 21, and is a part on another one of the sides that is made inside the accommodating unit 2, and which is separated from the heat-receiving passage 21 by the partition plate 5. The supplying passage 22 is opened at the top to lie successively to the condensing unit 3, and is opened at the bottom to lie successively to the heat-receiving passage 21. The liquid cooling medium that has been condensed at the condensing unit 3 turns into liquid droplets to drop down into the liquid level of the liquid cooling medium. The supplying passage 22 receives the liquid cooling medium that drops down from the condensing unit 3, and then supplies the liquid cooling medium to the heat-receiving passage 21 from down below by means of pressure difference. Note that the ebullient cooling device 1 is put in a sealed state completely. The liquid cooling medium is sealed into a container (i.e., the ebullient cooling device 1) that is in a vacuum state.

Explanations are made herein on the liquid cooling medium to be accommodated in the accommodating unit 2. The liquid cooling medium is a mixed liquid of water and ethanol. In the present embodiment mode, this mixed liquid has an ethanol concentration of roughly 50% by mass (or wt. %) . Ethanol exhibits a relatively low boiling point, namely, 78.6 °C. Ethanol is effective as a cooling medium for ebullient cooling device, because the boiling temperature is low. Moreover, in the present embodiment mode, the coolant water with roughly 65 °C is being flowed in the condensing pipe 31. Consequently, it is advisable that the boiling point can be higher than 65 °C moderately. In this perspective as well, it is effective to use ethanol for the mixed liquid.

Moreover, ethanol has a heat of evaporation (or latent heat) that is 855 (kJ/kg), and the heat of evaporation is larger than those of the other alcohols. Consequently, ethanol exhibits a larger limit heat flux. That is, using the mixed liquid of water and ethanol can make the resulting limit heat flux (MW/m²) larger than using the other alcohols. Since burnout is causedwhen a heat flux surpasses the limit heat flux, being a larger limit heat flux is more advantageous. Note that water has a larger heat of evaporation than does ethanol.

In addition, as shown in Fig. 3, ethanol exhibits a lower melting point (i.e., -114.1 °C) compared with those of the other alcohols. Consequently, the mixing amount that is necessary for the mixed liquid to exhibit a targeted melting-point temperature (e.g., less than -30 °C herein) can be less than those of the other alcohols. Since water has a larger heat of evaporation than do alcohols, the greater the water component is the larger a limit heat flux of the mixed liquid becomes. Even when ethanol is present in a small amount relatively, it is possible to lower the melting point. As a result, it is possible to make the water component greater and hence make the resulting limit heat flux larger. Thus, in the present embodiment mode, ethanol is an optimum option to be mixed with water.

For example, let us consider a case where HFE-7200 is used for the mixing with water. As shown in Fig. 3, HFE-7200 is effective in lowering the melting point of the resulting mixed liquid, because it exhibits a lower melting point than does ethanol. However, since the heat of evaporation is smaller considerably compared with that of ethanol, it becomes difficult to secure an adequate heat of evaporation after the mixing. That is, it becomes difficult to inhibit the occurrence of burnout.

Moreover, let us consider another case where 2-propanol is used for the mixing with water, for instance. 2-propanol is effective for inhibiting burnout from occurring, because it exhibits a larger heat of evaporation relatively. However, since 2-propanol exhibits a higher melting point than does ethanol, the same melting point as that of a water-ethanol mixed liquid is not obtainable unless 2-propanol is mixed in a greater amount than is ethanol. Eventually, the resulting heat of evaporation has declined, because it is necessary to augment a mixing ratio of 2-propanol with respect to water in order to lower the resultant melting point. In addition, the heat of evaporation of 2-propanol is smaller than that of ethanol. As described above, water-ethanol mixing is optimum in order to let both of the advantages, preventing freezing and inhibiting the occurrence of burnout, be demonstrated.

Explanations are made herein on the ethanol concentration. As illustrated in Fig. 4, it can be seen that the limit heat flux differs when the ethanol concentration differs in the mixed liquid of water and ethanol. As illustrated in Fig. 4, the limit heat flux becomes larger in a case where the ethanol concentration is roughly 75% by mass or less. That is, since being a larger limit heat flux is effective in order to inhibit burnout as described above, using the mixed liquid whose ethanol concentration is roughly 75% by mass or less is preferable for the inhibition of burnout.

However, the lower the ethanol concentration becomes, the higher the melting point becomes, and so the more likely it becomes to freeze. In particular, in order to be a liquid cooling medium to be used for ebullient cooling devices to be boarded on vehicle, it has been required in general that the liquid cooling medium be one which does not freeze at roughly -30 °C. Hence, a freezing experiment was carried out for the mixed liquid whose ethanol concentration was 40% by mass. As a result, it was ascertained that the aforesaid mixed liquid did not freeze in a -35 °C atmosphere. That is, when the ethanol concentration is 40% by mass or more, the mixed liquid exhibits a melting point being that temperature or less, and hence does not at all freeze even at -30 °C. It is thus possible to clear the required specification for installation in vehicle. Moreover, as aforementioned, the resulting limit heat flux becomes larger than that of ethanolic single component, because the water component whose limit heat flux is larger is included in the mixed liquid.

Thus, it is preferable that a liquid cooling medium to be used for vehicular ebullient cooling device can be a mixed liquid (e.g., water plus ethanol) whose ethanol concentration is from 40% by mass or more to 75% by mass or less. In accordance with this setting, the freezing can be prevented, and the burnout can be inhibited.

Moreover, it is preferable that the ethanol concentration can be 45% by mass or more in order to furthermore securely prevent the freezing. For example, when the ethanol concentration is 50% by mass approximately, the resulting melting point becomes smaller than -40 °C , and hence it is possible to clear the required specification for cold area (e.g., being non-freezable at -40 °C) as well. That is, by using the mixed liquid whose ethanol concentration is 45-75% by mass, it is possible to more securely prevent the freezing, and to make the limit heat flux larger so as to inhibit the burnout.

Note herein that, in the present embodiment mode, the separation distance between the heat-transferring wall portion 21a and the facing wall portion 23a is made to be roughly 1 mm. In Non-patent Literature No. 1, the following are described: heat transfer is facilitated, compared with pool boiling, when making the aforementioned separation distance (i.e., the gap between the heat-transferring wall portion 21a and the facing wall portion 23a) smaller. Note that "pool" is a case where the separation distance has such a sufficient distance as 10 mm or more. For example, in cases where the separation distance is 2 mm, 1 mm and 0.6 mm, respectively, the resulting heat transfer is facilitated remarkably in lower heat-flux range. The larger the heat transfer coefficient is, the more favorable the resultant cooling performance becomes.

In the same construction as that of the present embodiment mode, the aforementioned separation distance was altered to experiment differences between the resulting heat transfer coefficients. In this experiment, the mixed liquid with an ethanol concentration of 60% by mass was used. The heat flux in the heating element was from 1-2 (MW/m²). As illustrated in Fig. 5, the heat transfer coefficient rose when the separation distance was 2 mm or less. However, since a limit bubble diameter is roughly 1.5 mm in the mixed liquid of water and ethanol, it is believed that favorable heat transfer can be carried out maximallyup to 3 mm that is equivalent to the double of that value. That is, provided that the separation distance is 3 mm or less, advantageous effects are obtainable in the prospect of heat transfer. And, the separation distance can preferably be 2 mm or less. A more preferable separation distance can be from 0.5 mm or more to 1.5 mm or less in which 1 mm makes the center.

Moreover, a similar experiment was carried out for the separation distance between the partition plate 23 and the wall portion 22a on the side of the supplying passage 22 (being referred to as a "return-separation distance" hereinafter) as well. As illustratedinFig. 6, although the heat transfer coefficient upgrades sharply as the return-separation distance is headed from 1 mm for 2 mm, the improvement in the heat transfer coefficient is not seen so much when it is 2 mm or later. Taking such a demerit that making the return-separation distance greater has resulted in making the device larger, it is understood that the return-separation distance can suitably be in the vicinity of 2 mm in order to upgrade the heat transfer coefficient while inhibiting the device frombecoming larger. The return-separation distance was made to be 2 mm in the present embodiment mode.

Subsequently, in the present embodiment mode, the ethanol concentration in the mixed liquid was changed to carry out an experiment on the resulting heat transfer coefficients while setting the separation distance at 1 mm between the heat-transferring wall portion 21a and the facing wall portion 23a. As illustrated in Fig. 7, it is understood the heat transfer coefficient became higher (roughly 7.8 × 10⁴ (W/m²·K)) when the ethanol concentration was 50% by mass. Moreover, even when the ethanol concentration was 60% by mass and 70% by mass, it is understood that the heat transfer coefficients became higher (roughly 6.5 × 10⁴ (W/m²·K) at 60% by mass, and roughly 6.3 × 10⁴ (W/m²·K) at 70% by mass).

As to the limit heat flux, it became larger gradually from 75% by mass toward 30% by mass, as illustrated in Fig. 4. From the viewpoints of the burnout inhibition (e.g., 75% by mass or less), the freeze prevention (e.g., 40% by mass or more), and the aforementioned heat transfer coefficient, it is possible to say that the ethanol concentration that is suitable for mounting on vehicle can roughly be from 45% by mass or more to 75% by mass or less that centers about 50-70% by mass where the heat transfer coefficient is higher. More preferably, it can be from 45% by mass or more to 55% by mass or less in which 50% by mass makes the center at which the heat transfer coefficient is the highest. In the present embodiment mode, the separation distance was 1 mm, and the ethanol concentration in the mixed liquidwas 50% by mass. As aforementioned, in accordance with these settings, it is possible to prevent the liquid cooling medium from freezing, and the burnout can be inhibited from occurring.

Note that, as illustrated in Fig. 8 (the upper diagrams), burnout, in particular, film boiling occurs in the vicinity of the inner face of the heat-transferringwall portion 21a that corresponds to the central part of the heating element "Z" (namely, the part that becomes the highest temperature). When film boiling occurs, no heat transfer is carried out in a region where it has occurred (namely, a film-boiling region), because the liquid cooling medium cannot make contact with the heat-transferring wall portion 21a therein. Because of this, the cooling performance has declined. Moreover, the transfer of heat is expanded to the surrounding area while avoiding the film-boiling region. That is, the heat-transfer distance has become longer. Thus, the thermal resistance becomes larger with respect to heat that conveys through the heat-transferring wall portion 21a, and hence the heat-transferring performance has also been declined. For example, in a case where the heat-generation density of the heating element "Z" is one that exceeds 1 MW/m², film boiling might possibly arise in an ethanolic single-component liquid cooling medium.

However, it is possible to inhibit the occurrence of film boiling by making use of the aforementioned preferable mixed liquid as a liquid cooling medium. Because film boiling is inhibited, the liquid cooling medium makes contact with the heat-transferring wall portion 21a's inner face, and the expansion of heat is prevented on or during heat transfer, as illustrated in Fig. 8 (the lower diagrams). Because the heat-transfer distance also becomes shorter, the cooling performance and heat-transferring performance upgrade.

Moreover, in the relationship between the heat-generation density of the heating element "Z" and the ethanol concentration in a sealed-system ebullient cooling device, the element's temperature became higher slightly, regardless of the heat-generation density, when the ethanol concentration was 80-100% by mass, as illustrated in Fig. 9. However, any difference is not seen more or less in the element's temperature even when the ethanol concentration changed. This is presumed as follows: since the boiling point becomes higher as the ethanol concentration becomes less when being an open system, it is predicted that the element's temperature rises in the open system because the heat-transferring performance declines as the ethanol concentration becomes less; however, since the boiling point depends on the pressure in a sealed system and then the pressure depends on the condensation capacity, the difference in the boiling point of mixed cooling medium has disappeared virtually, independent of the ethanol concentration, due to the fact that the condensation capacity is constant in the sealed system. Consequently, when being a sealed system, since the decline of the boiling point, which results from making the ethanol concentration less in the mixed cooling medium, does not occur, and since the decline of the heat-transferring performance being accompanied therewith does not occur, it is seen that it can be better to make a sealed system in a case of employing a mixed cooling medium. Moreover, it is advisable that the ethanol concentration can be 80% by mass or less, because the element's temperature became higher slightly when the ethanol concentration was 80-100% by mass. From this result as well, it is understood that an effective ethanol concentration can be 40-75% by mass.

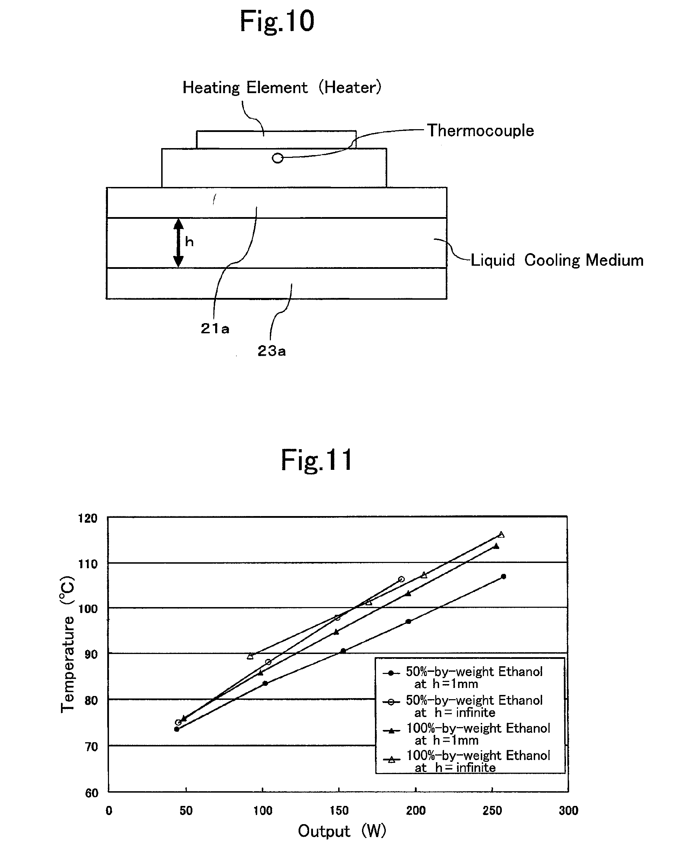

Here, an experiment was further made for relation ships between the aforementioned separation distances and the element's temperatures. Fig. 10 is a schematic diagram that illustrates a simplified make of the experiment. Fig. 11 is a diagram that illustrates relationships between outputs of heating element and measured temperatures of thermocouple in the experiment. In Fig. 11, the horizontal axis specifies the outputs (W) of heating element, and the vertical axis specifies the temperatures (°C).

In the experiment, though the basic makeup was the same as that of the aforementioned embodiment mode, a thermocouple was put in place between the heat-transferring wall portion 21a and the heating element (or heater) as illustrated in Fig. 10, and then the temperatures were measured. The liquid cooling medium was a mixed liquid of water and ethanol. The separation distance between the heat-transferring wall portion 21a and the facing wall portion 23a was labeled "h." The measured temperatures for the thermocouple corresponded to the element's temperatures (or heating element's temperatures). The experiment was carried out with respect to cases where "h" was 1 mm and infinite for the liquid cooling medium whose ethanol concentration was 50% by mass, and to cases where "h" was 1 mm and infinite for the liquid cooling medium whose ethanol concentration was 100% by mass. The "infinite" herein was results of doing the experiment with regard to cases where "h" = 10 mm or more, namely, a sufficient length was given therefor, and meant the "pool."

According to the results of the experiment, it was understood that the element's temperature became the lowest in the case where the ethanol concentration was 50% by mass and "h" = 1mm, as illustrated in Fig. 11. That is, the cooling performance becomes the highest when making the liquid cooling medium of the mixed liquid with 50%-by-mass ethanol concentration and being h = 1 mm. For example, even in the case of using the liquid cooling medium with identical 50%-by-mass ethanol concentration, the element's temperature always became lower in the case of being "h" = 1 mm than in the case where "h" was infinite.

Moreover, in the case where the ethanol concentration was 100% by mass, the element's temperature became lower in the case of "h" = 1 than in the case where "h" was infinite when the element's output was smaller. However, the element's temperature became higher in the case of "h" = 1 than in the case where "h" was infinite when the element's output was greater. That is, in the case of 100%-by-mass ethanol, even when the separation distance "h" between the heat-transferring wall portion 21a and the facing wall portion 23a is made less, the effect resulting therefrom is none at all, or that effect is a little bit, if any.

It has been understood from the conventional paper that, inanarrowgap, the heat transfer coefficient upgrades because vapors that generate at the flow passage's lower part pushes vapors that are present at the flow passage's upper part away. And, since the density of vapors resulting from a mixed liquid of water and ethanol is smaller than the density of vapors resulting from an ethanolic single component, the ascending speed of bubbles is faster in the former than in the latter. Consequently, it is assumed that, in a narrow gap, the improvement in the heat-transferring performance becomes greater in a mixed-component cooling medium of water and ethanol than in a single-component cooling medium of ethanol.

Note that, in the present embodiment mode, the separation distance is set at 1 mm and the ethanol concentration is set at 50% by mass as optimum modes. However, these numerical values are not those from which errors are excluded. Even when deviations arise more or less in the numerical values, the aforementioned advantages can be demonstrated. That is, the numerical values in the present embodiment mode possess breadths more or less, and so certain deviations resulting from errors, and the like, are involved in the present embodiment mode. For example, for the ethanol concentration being 50% by mass, it is allowable that the lower limit can fall within a range of 49-48% by mass, and that the upper limit can fall within a range of 51-52% by mass. Similarly, for the separation distance being 1 mm, too, it is permissible that it can be 0.9-1.1 mm.

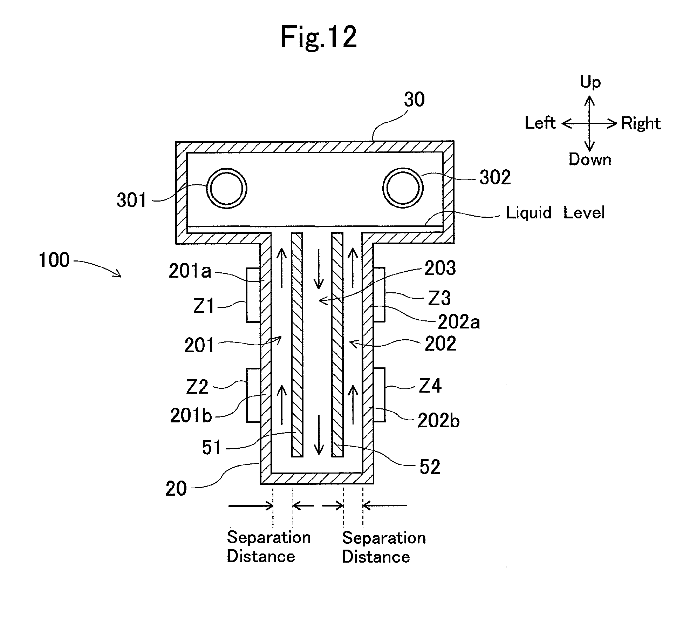

Note herein that, as amodifiedmode of the present embodiment mode, it is even allowable that the ebullient cooling device can have a construction shown in Fig. 12. Fig. 12 is a diagram that illustrates an ebullient cooling device 100, and which corresponds to the "A"-"A" cross-sectional diagram. As illustrated in Fig. 12, the ebullient cooling device 100 comprises a condensing unit 30, and an accommodating unit 2 0 whose interior is divided by two partition plates 51 and 52 . The accommodating unit 20 is equipped with a first heat-receiving passage 201, a second heat-receiving passage 202, a supplying passage 203, and the partition plates 51 and 52.

The first heat-receiving passage 201 is formed as a rectangular parallelepiped substantially. Roughly speaking, the first heat-receiving passage 201 is a part that is surrounded by side wall faces that include the following: the partition plate 51 on the left side; and a side wall face including heat-transferring wall portions 201a and 201b onto which heating elements "z1" and "Z2" are installed. The second heat-receiving passage 202 is formed as a rectangular parallelepiped substantially. Roughly speaking, the second heat-receiving passage 202 is a part that is surrounded by side wall faces that include the following: the partition plate 52 on the right side; and a side wall face including heat-transferring wall portions 202a and 202b onto which heating elements "Z3" and "z4" are installed.

The heat-receiving passages 201 and 202 are opened at the top to lie successively to the condensing unit 30, and are opened at the bottom to lie successively to the supplying passage 203, respectively. Inside the heat-receiving passages 201 and 202, the aforementioned liquid cooling medium is accommodated. A separation distance between the side wall face, which includes the heat-transferring wall portions 201a and 201b, and the partition plate 51 is made to be 3 mm or less (e.g., roughly 1 mm herein). A separation distance between the side wall face, which includes the heat-transferring wall portions 202a and 202b, and the partition plate 52 is also made to be 3 mm or less (e.g., roughly 1 mm herein).

The supplying passage 203 is formed as a rectangular parallelepiped substantially, and is a part that is interposed by the partition plate 51 and the partition plate 52. The supplying passage 203 is opened at the top to lie successively to the condensing unit 30, and is opened at the bottom to lie successively to the heat-receiving passages 201 and 202. A separation distance (or return-separation distance) between the partition plate 51 and the partition plate 52 is made to be roughly 2 mm.

The condensing unit 30 is positioned above the heat-receiving passages 201 and 202, and above the supplying passage 203. In the condensing unit 30, there are disposed condensing pipes 301 and 302 in which coolant water flows. The liquid cooling medium (i.e., the mixed liquid) according to the present embodiment mode, which is accommodated in the heat-receiving passages 201 and 202, receives heat from the respective heating elements "Z1" through "Z4," and then boils. Vapors having risen are condensed at the condensing unit 30. The condensed liquid cooling medium drops down into the supplying passage 203 mainly. The supplying passage 203 receives the liquid cooling medium that drops down from the condensing unit 30, and then supplies the liquid cooling medium to the heat-receiving passages 201 and 202 from down below by means of pressure difference (see the arrow in Fig. 12). In accordance with this setting, too, the same advantages as those of the present embodiment mode can be demonstrated, because the aforementioned mixed liquid is used.

It is even allowable that the ebullient cooling device according to the present embodiment mode can have a construction like the following: the heating element is constituted of a substrate, and a heat-generating element being disposed on the substrate; and not only a hole is formed in one of the side walls of the accommodating unit but also the substrate is put in place so as to block that hole, and thereby the substrate makes contact with the cooling medium directly. In that case, the substrate is considered a part of the accommodating unit, and the substrate corresponds to the heat-transferring wall portion. Moreover, it is also permissible that it can have such a construction that the heating element is put in place within the accommodating unit to be immersed in the cooling medium. Moreover, as for a heat exchanger, it is not limited to such a heat exchanger in which the cooling medium is being held or reserved within a bottomed container, but it is even allowable that it can have such a construction in which the cooling medium is flowing without being held or reserved. In accordance with the present invention, it is possible even for those constructions as described above to demonstrate the same advantages as those mentioned above.

## Claims

1. An ebullient cooling device being **characterized in that**:
it comprises
an accommodating unit in which a liquid cooling medium is accommodated, the liquidcoolingmediumreceivingheat that results from a heating element;
said liquid cooling medium is a mixed liquid comprising at least two types of liquids whose boiling points differ;
said accommodating unit has:
a heat-transferring wall portion that conveys the heat of said heating element to said liquid cooling medium; and
a facing wall portion that faces said heat-transferring wall portion by way of said liquid cooling medium; and
a separation distance between said heat-transferring wall portion and said facing wall portion is 3 mm or less.

2. The ebullient cooling device as set forth in claim 1, wherein the separation distance between said heat-transferring wall portion and said facing wall portion is 2 mm or less.

3. The ebullient cooling device as set forth in claim 2, wherein the separation distance between said heat-transferring wall portion and said facing wall portion is from 0.5 mm or more to 1.5 mm or less.

4. The ebullient cooling device as set forth in either one of claims 1 through 3, wherein said illiquid cooling medium is a mixed liquid of water and ethanol.

5. The ebullient cooling device as set forth in claim 4, wherein said mixed liquid has an ethanol concentration of from 45% by mass or more to 55% by mass or less.
